# EUROPEAN PATENT APPLICATION

(11) **EP 3 118 902 A1**
(43) Date of publication of application: **18.01.2017**
(21) Application number: 15176939.5
(22) Date of filing: 15.07.2015
(51) Int. Cl.: H01L 31/18

(54) **METHOD FOR RECYCLING PHOTOVOLTAIC SOLAR CELLS MODULE**

(71) Applicant: Université de Liège, 4031 Angleur (BE)
(72) Inventor: Schrijnemakers, Audrey, 4000 Liege (BE); Boschini, Frédéric, 4000 Liege (BE); Cloots, Rudi, 4000 Liege (BE)

(57) **Abstract**

A method for recycling/recovering a core (9) of a silicon solar cells module (8) in its raw components comprising :
d) providing a core (9) of a silicon solar cells module wherein the cells (6) are interconnected by connection ribbons (5) and embedded in an encapsulation layer (4) said encapsulation layer (4) being sandwiched between a back sheet (7) and a front glass plate (3) ;
e) introducing the core (9)of the silicon solar cells into a reactor;
f) dismantling the solar cells core (9) by hydrothermal treatment under subcritical atmosphere to generate recovered clean glass component and a residual laminate (10).

## Description

The present invention relates to a method for recycling/recovering photovoltaic(PV) cells module by hydrothermal treatment, particularly the method comprise a dismantling of photovoltaic cells core of the module into its raw components under hydrothermal subcritical conditions preferably under oxidant hydrothermal subcritical conditions.

Photovoltaic modules production has considerably increased during the last decades and we are now in a stage of end-of-life modules. Moreover there are also a significant number of wastes generated during the production process or resulting from mechanical damages in the module during transport, delivery and / or placement.

Consequently it is becoming essential to recycle photovoltaic cells modules in order to reduce a negative environmental impact. European Union has even issued a guideline called European WEEE directive to fix rules about end of live photovoltaic modules. According to such guideline, the entire photovoltaic module in terms of its raw components should be recovered.

A photovoltaic module contains components such as glass, aluminum, organic material, silicon and metallic contacts that may be recovered and reused, either in new photovoltaic modules or in other products.

Typically, a photovoltaic module is made of silicon solar cells, also called silicon wafers ; metal contacts between the cells; an encapsulation layer that encloses the cells and the contacts; a front glass plate and a back-side foil for isolation or alternatively a second glass plate on the back side. The back-side foil is a polymeric layer generally made of halogenated-polymers such as for example polyvinylidene fluoride (PVDF) whereas the encapsulation layer is generally made of polyethylene vinyl acetate (EVA). The metallic contacts between the cells are generally made of silver/tin/lead alloys.

The photovoltaic module is generally framed with aluminum and contains a junction box.

Recycling/recovery starts by a primary manual dismantling at room temperature of the aluminum frame and the metallic contacts. Such primary dismantling is induced by a mechanical strain on the glass plate generating small defects in glass that may lead to cracking and/or swelling of the PV module. As the encapsulation layer sticks hardly to the photovoltaic cells and to the glass plate, breakage of the photovoltaic silicon cells cannot be avoided and reuse of all photovoltaic cells is difficult.

Currently, the most common way to separate the raw components of a photovoltaic cell module consists in burning the encapsulation layer in a conveyor belt furnace at a temperature from 450°C to 600°C. By this burning method, organic materials of the photovoltaic module cannot be reused but inorganic fractions such as glass, metallic ribbons, silicon wafers are recovered. Nevertheless the burning method has significant drawbacks:
- combustion of halogenated-polymers makes waste gas treatment necessary;
- metallic contacts components are melting and diffusing at high temperature into other photovoltaic components such as glass and silicon wafers. It makes purification steps necessary for recovery of high purity silicon;
- vaporization of heavy metals such as tin, lead, silver during burning of the encapsulation layer makes waste gas treatment necessary;
- poor separation of inorganic fraction due to the metallic contamination affects quality of recovered components.

There is therefore a need to develop a new, preferably greener recycling method providing recycled/recovered raw components of a photovoltaic cells module without metallic contamination and keeping/recovering their initial electrical property such as semiconductor conductivity.

We have now found a method for photovoltaic cells module recycling/recovering comprising one step of dismantling the core of the module in water under subcritical condition, preferably in oxidant subcritical condition that allows to degrade and remove organic compounds, reduces mass and volume of the waste photovoltaic module and to recover valuable components with a low percentage of metallic contamination. Clean glass component is also generated by a one-step method of dismantling.

According to a first embodiment, the method according to the invention comprises a dismantling in a reactor of the solar cell module in order to separate glass component from the other components of the module by using subcritical hydrothermal conditions.

Water is environmentally the safest material and the cheapest of all solvents. It can act as a mineralizer or a catalyst under elevated pressure-temperature conditions. Thermodynamic and transport properties of subcritical water are remarkably different from those of ambient water or from water in supercritical condition. A method using water in subcritical condition has the advantage to work under pressure and temperature that are lower than water in supercritical state and is therefore safer and economic on an energetic point of view. Moreover water in subcritical water condition is more easily processed at industrial level for large quantity of modules.

Under water subcritical conditions, solubility of nonpolar species increases, whereas the solubility of ionic and polar compounds decreases. As a result, there is a drop of polarity of water, molecular mobility increases due to a decrease in solvent viscosity (η). Drastic changes of ionic hydration are brought about by a decrease in dielectric constant (ε) and density (ρ).

The term "hydrothermal treatment" has been defined in the art as "any heterogeneous chemical reaction in presence of a solvent (whether aqueous or non-aqueous) above room temperature and at pressures greater than 1 atm ( or 0.1 MPa) in a closed system. However in the present invention, hydrothermal treatment refers to a method involving dismantling reactions carried out in water facilitated by high temperatures and high pressures conditions.

Water plays an important role in hydrothermal photovoltaic modules recycling treatment wherein it does not only act as solvent, but is also a main reactant for degradation of organic components. Indeed, at high pressure-temperature conditions usually employed in hydrothermal processes, water has a high reactivity and is able to break chemical bonds in complex molecules like polymers and convert them into simpler compounds. Water used in hydrothermal treatment is able to depolymerize the back-side foil and to generate organic flakes.

Hydrothermal treatment in subcritical conditions involves a combination of a temperature and a pressure that allows water to remain liquid at a temperature above its boiling point.

Typically in subcritical conditions, temperature of water varies between its atmospheric boiling point and its critical temperature (374°C), preferably between 200 and 220°C and the pressure has to be raised between 0.1 and 21.8 MPa preferably 2 MPa

Hydrothermal treatment are carried out in a reactor specially designed to resist to such high temperature and pressure conditions, either in a vertically or an horizontally position such as drum reactor.

When photovoltaic solar cells cores are submitted to hydrothermal treatment in subcritical conditions, glass peeling occurs off the core. Simultaneously the back foil sheet also peels off from the core and may be partly depolymerized. Organic flakes and clean glass are generated after one step of hydrothermal treatment. It also remains a residual laminate wherein the silicon solar cells and its metal contacts needs subsequent treatment to be recovered.

Hydrothermal treatment may be repeated several times on the residual laminate provided from a previous hydrothermal treatment to obtain further residual fragments and to further eliminate organic compounds.

According to a another embodiment, the method according to the invention comprises a dismantling in a reactor of the solar cell module in order to separate glass component from the other components of the module by using oxidant subcritical hydrothermal conditions.

Oxidant subcritical conditions can be generated by using water with a liquid or gaseous oxidizing agent.

A Liquid oxidizing agent is a oxidant acid particularly inorganic or organic oxacid such as nitric acid; peroxynitric acid, chromic acid, manganic acid, hydrogen peroxide, halogenated oxacid , and the like or a combination thereof; or a compound generating ozone or oxygen. Practically nitric acid and hydrogen peroxide or a mixture thereof are preferred because they exhibit lower toxicity for environment and they are not damaging reactor vessel.

Gaseous oxidizing agents are for example oxygen, ozone, fluor, chlore, brome, iode, protoxyde of nitrogen and the like. The most preferred gaseous oxidizing agent is oxygen.

When photovoltaic solar cells cores are submitted to hydrothermal treatment in oxidant subcritical conditions, glass peeling occurs off the core and residual fragment are generated. Simultaneously the back foil sheet is also peeling and de-polymerization progress more quickly than with water in subcritical conditions. The back foil sheet is totally eliminated from the core of the module.

Oxidant hydrothermal treatment may be repeated several times on residual fragments resulting from a previous dismantling step and allows to recover most components of the PV module, particularly silicon and the metal components.

In a preferred embodiment, an oxidant hydrothermal treatment under subcritical condition of the method according to the invention comprises an oxidant acid, preferably an acid selected from the group comprising or consisting of nitric acid, hydrogen peroxide or a combination thereof.

Oxidant hydrothermal treatment in subcritical conditions such as with nitric acid, allows advantageously to improve de-polymerization of the back sheet in the core or to improve de-polymerization of the encapsulation layer in the laminate. Oxidant hydrothermal treatment in subcritical conditions allows to recover silicon. Selective recovery of metals are carried out by precipitation and/or electrolysis treatments.

The subcritical conditions using nitric acid in water are performed at a temperature between 107°C and 374°C, preferably 130°C and 180°C, most preferably at 150°C. Preferably the subcritical conditions are maintained in the reactor during several hours at an autogenous pressure of 0.5 to 2.5 MPa.

In another preferred embodiment, the oxidant hydrothermal treatment under subcritical condition of the method according to the invention comprises a supply of oxidant gas in the reactor. The most preferred oxidant gas is oxygen.

The subcritical conditions using oxygen as oxidant are performed at a temperature between 150°C and 374°C, preferably between 150 and 250°C, most preferably at 190°C. Preferably the subcritical conditions are maintained during several hours with a permanent supply of oxygen.

### BRIEF DESCRIPTION OF THE DRAWINGS

The invention may be more completely understood in consideration of the following detailed description of embodiments according to the invention with the accompanying drawings, in which:
FIG. 1 illustrates a schematic view of a photovoltaic module (8), its core (9) and its laminate (10) that can be dismantled according to the invention.
FIG.2 illustrates a schematic view of a reactor that implements the method according to the invention.

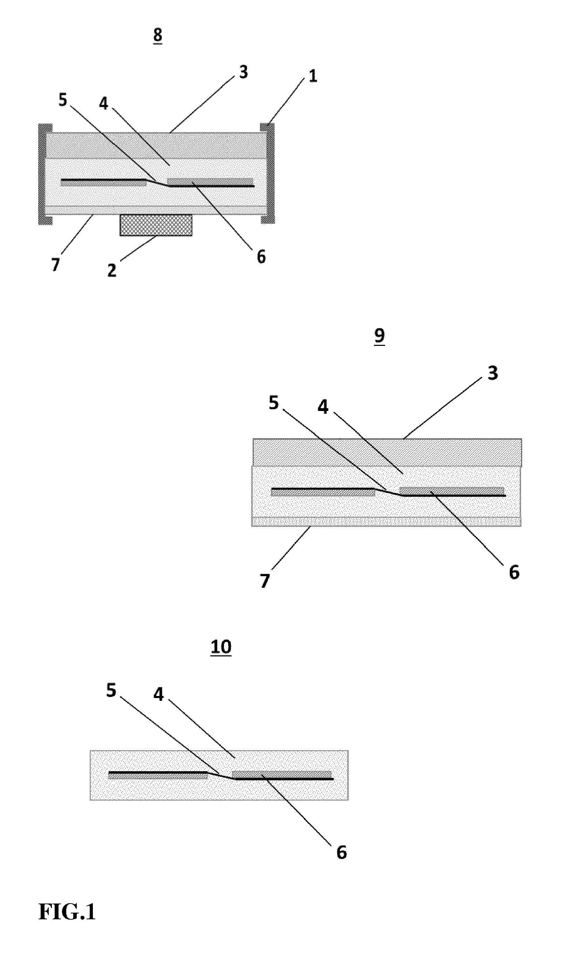

In figure 1, a photovoltaic module (8) is schematically illustrated. The module (8) comprises a laminate (10) made of a photoactive material such as silicon solar cells (6) that are connected together with metal contacts (5) between the cells (6). The silicon solar cells (6) are generally made silicon and are encapsulated in a polymeric layer also called encapsulation layer (4). The encapsulation layer (4) may be polyethylene vinyl acetate also called EVA or PEVA.

The laminate (10) is protected by a front glass plate (3) and a back side foil (7) made of a polymeric layer comprising halogenated polymers, for example polyvinylidene fluoride. Such an assembly (9) is called core of photovoltaic module. The core is generally framed with aluminum (1). The module still contains a junction box (2) at the back side of the module(8).

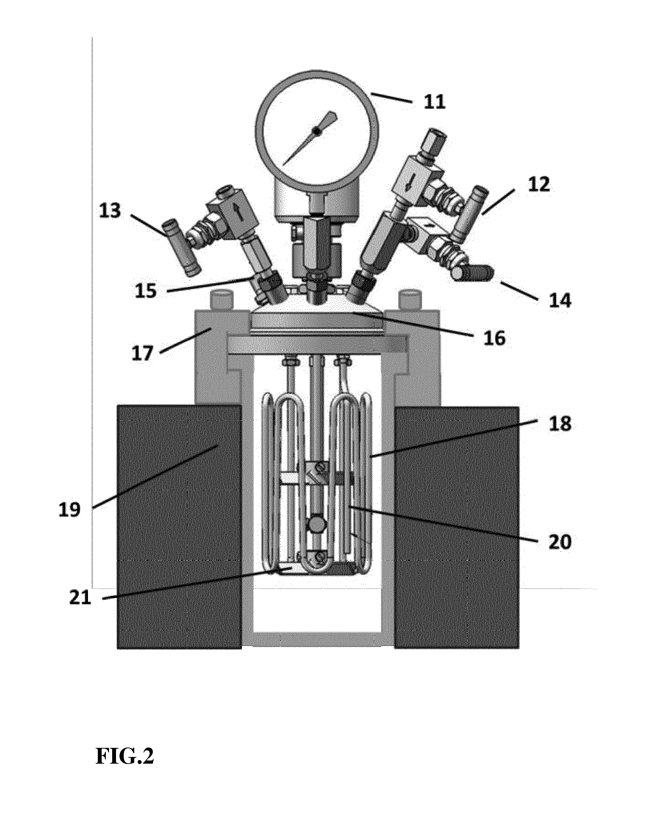

In figure 2, a reactor is schematically illustrated. The reactor is made of stainless steel. and comprises the following elements :
A pressure gage (11) connected at the top of the reactor to measure ambient pressure inside the reactor
A gas inlet valve (12) and a gas release valve (13) to respectively introduce gas into the reactor or to release it.

A liquid sampling valve (14) allows to collect sample from the reactor during the hydrothermal treatment.

A safety rupture disc assembly (15) allows to drop the pressure to 1 atm (or 0.1 MPa) in case of emergency.

A head with cooling coil (16) is used to adjust temperature during hydrothermal treatment and to cool the reaction medium at the end of the treatment

A sealing clamp(17) allows to seal the reactor during treatment at high temperature and pressure

A cooling coil serpentine (18) is located inside the reactor and used to control temperature. The reactor is partially located inside a furnace (19)

A dip tube (20) allows to extract samples from inside of the reactor during hydrothermal treatment

A stirrer (21) allows to homogenize the oxidant reaction medium

Inside diameter and height of the reactor are 140 mm and 385 mm respectively. Its total capacity is approximatively 5.9I. The real content volume with stirrer, cooling coil and dip tube system is around 5.6I.

The reactor allows the treatment of piece of PV panel with one solar cell height and three solar cells length to be dismantled. Samples made of core of PV modules of about (10cm x 10cm) are used

During treatment samples are slipped horizontally between the loops of the cooling serpentine. Hydrothermal treatment in subcritical conditions (180°C<T<374°C) in pure water for a period less than or equal to 6 hours are performed. Time processing may be reduced by addition of a base such as sodium hydroxide

### DETAILED DESCRIPTION

The following detailed description should be read with reference to the drawings. The detailed description and the drawings, which are not necessarily to scale, discloses embodiments according to the invention and are not intended to limit the scope of the invention.

### Example 1: method of dismantling with nitric oxide or (nitric acid + hydrogen peroxide) subcritical atmosphere

First, the junction box (2) (approximatively 2 wt.% of the total weight of the module) and aluminum frame (1) (approximatively 16 wt.% of the total weight of the module) are mechanically removed from an out-of-order photovoltaic module (8) during a primary dismantling.

After this primary dismantling, the core of the panel remains. The core of the panel is then introduced into the reactor (Parr instruments model 4580 hydrothermal bomb) (figure 2) together with acid nitric at a concentration 32wt.% in de-ionized water and exposed to an oxidant subcritical atmosphere. Regarding this example, the oxidant subcritical atmosphere is formed by nitric acid 32 wt.% as medium but nitric acid concentration can be halve by hydrogen peroxide 30 wt.% in a 2:1 molar ratio. In such a case, the medium is made of nitric acid or nitric acid/hydrogen peroxide mix in de-ionized water with quantity of 2.4l.

Inside the reactor, the atmosphere temperature was set at 150°C. The autogenous pressure was controlled and measured with value around - 0.5 MPa. These atmosphere conditions were guaranteed for a holding time of 3 hours.

Further to the 3 hours oxidant subcritical atmosphere treatment in the reactor, two fractions are generated in one step from the core of the photovoltaic module. The solid fraction is made of glass/silicon fragments mix and a tin precipitate (which represents approximatively 70 wt.% of total weight of the module) while the liquid fraction contains dissolved metallic ribbons (also called metal connections) and metallic grid contact (which represents approximatively 1 wt.% of total weight of the module) are leached from the silicon solar cells. The liquid fraction also contains organic residues resulting from the backsheet oxidation and encapsulation layer oxidation (approximatively 11 wt.% of total weight of the module). A tin precipitate can be removed from the solid fraction by leaching with a slight basic solution - NH₄OH 1M. Glass/silicon fragments mix could be separated by a mechanical process. Further treatment is still needed to go on with the recovery of raw metal component. Selective recovery of metals are carried out by precipitation and/or electrolysis treatment. Metals oxidation by nitric acid releases a huge volume of NOx gas (particularly NO₂ and NO) and pressure rises sharply during the oxidation reaction to reach a pressure value higher than - 2.5 MPa.

### Example 2: method with water in subcritical atmosphere- no influence of CO₂

First process consisting in removing mechanically the junction box (2) and aluminum frame (1) from the out-of-order photovoltaic module (8) is identical to the primary dismantling described in example 1. After this first dismantling, the core of the panel is introduced into the reactor (Parr instruments model 4580 hydrothermal bomb) (figure 2) and exposed to subcritical atmosphere. Regarding this example, the subcritical atmosphere is formed by water as medium. Reactor dimensions and capacity is identical than previously described in example 1. Regarding this example, the medium is made of water with quantity of 2.4l.

Before heating the reactor tank, the air volume above the liquid water media is substituted by a pressure of 0.1 MPa of carbon dioxide gaz (CO₂). Inside this reactor, the atmosphere temperature was set to 200°C. The autogenous pressure was controlled and measured with value around 1.6 MPa. These atmosphere conditions were guaranteed for holding time of 6 hours. Exposed to the subcritical atmosphere of the reactor, fractions cannot be released from the core of photovoltaic module. Only protective glass (3) and halogenated-polymers from the backsheet peel off slightly from the core of photovoltaic module.

### Example 3: method with water in subcritical atmosphere- no influence of nitrogen

First process consisting in removing mechanically the junction box (2) and aluminum frame (1) from the out-of-order photovoltaic module (8) is identical to the primary dismantling described above in the example 1. After this first process, the core of the panel is introduced into the reactor (Parr instruments model 4580 hydrothermal bomb) (figure 2) and exposed to subcritical atmosphere. Regarding this example, the subcritical atmosphere is formed by water as medium. Reactor dimensions and capacity is identical than previously described in example 1. Regarding this example, the medium is made of water with quantity of 2.4l. Before heating the reactor tank, the air volume above the liquid water media is substituted by a pressure of 0.1 MPa of nitrogen gaz (N₂). Inside this reactor, the atmosphere temperature was set to 200°C. The autogenous pressure was controlled and measured with value around 1.6 MPa. These atmosphere conditions were guaranteed for holding time of 6 hours. Exposed to the subcritical atmosphere of the reactor, fractions cannot be released from the core of photovoltaic module. Only protective glass (3) and halogenated-polymers from the backsheet peel off slightly from the core of photovoltaic module.

### Example 4: method with water in subcritical atmosphere- no influence of air

First process consisting in removing mechanically the junction box (2) and aluminum frame (1) from the out-of-order photovoltaic module (8) is identical to the primary dismantling described above in the example 1. After this first process, the core of the panel is introduced into the reactor (Parr instruments model 4580 hydrothermal bomb) (figure 2) and exposed to subcritical atmosphere. Regarding this example, the subcritical atmosphere is formed by water as medium. Reactor dimensions and capacity is identical than previously described in example 1. Regarding this example, the medium is made of water with quantity of 1.4l. Before heating the reactor tank, the gas volume (approximatively 4l) above the liquid water media is composed of air (approximatively 78 mol.% N₂ and 21 mol.% O₂). Inside this reactor, the atmosphere temperature was set to 200°C. The autogenous pressure was controlled and measured with value around 1.5 MPa. These atmosphere conditions were guaranteed for holding time of 6 hours. Exposed to the subcritical atmosphere of the reactor, fractions cannot be released from the core of photovoltaic module.

### Example 5: method with water in subcritical atmosphere- influence of water quantity

First process consisting in removing mechanically the junction box (2) and aluminum frame (1) from the out-of-order photovoltaic module (8) is identical to the primary dismantling described above in the example 1. After this first process, the core of the panel (9) is introduced into the reactor (Parr instruments model 4580 hydrothermal bomb) (figure 2) and exposed to subcritical atmosphere. Regarding this example, the subcritical atmosphere is formed by water as medium. Reactor dimensions and capacity is identical than previously described in example 1. Regarding this example, the medium is made of water with quantity of 2.4l. Here, it is possible to use the same water medium several times. Identical results were obtained when keeping the same water medium for five consecutive badge treatments. Before heating the reactor tank, the gas volume (approximatively 3l) above the liquid water media is composed of air (approximatively 78 mol.% N₂ and 21 mol.% O₂). Inside this reactor, the atmosphere temperature was set to 200°C. The autogenous pressure was controlled and measured with value around 1.5 MPa. These atmosphere conditions were guaranteed for holding time of 6 hours. Exposed to the subcritical atmosphere of the reactor, protective glass (3) and halogenated-polymers from the backsheet or the entire backsheet (7) versus its composition peel off from the core of photovoltaic module (figure 3). Recovered glass is clean and can directly reintegrate a glass production line. The residual laminate (10) constituted of silicon solar cells and its connection ribbon embedded between encapsulation layers (figure 4), needs subsequent treatment to recover the other components. It could be the process described in the example 1 or in the example 6.

### Example 6: method with water in subcritical atmosphere- influence of O₂

First process consisting in removing mechanically the junction box (2) and aluminum frame (1) from the out-of-order photovoltaic module (8) is identical to the primary dismantling described above in the example 1. After this first process, the core of the panel is introduced into the reactor (Parr instruments model 4580 hydrothermal bomb) (figure 2) and exposed to subcritical atmosphere. Regarding this example, the subcritical atmosphere is formed by water as medium. Reactor dimensions and capacity is identical than previously described in example 1. Regarding this example, the medium is made of water with quantity of 2.4l. Inside this reactor, the atmosphere temperature was set to 200°C. The autogenous pressure was controlled and measured with value around 1.5 MPa. When temperature reaches 200°C inside the reactor tank, a pressure of 0.1 MPa of dioxygen gas (O₂) was added to the subcritical atmosphere. As oxygen was consumed, reactor tank was continuously fed with oxygen by step of 0.1 MPa. These atmosphere conditions were guaranteed for holding time of 6 hours. Exposed to the oxidant subcritical atmosphere of the reactor, all fractions can be released from the core of photovoltaic module. The solid fraction contains protective glass (3), solar cells (6) fragments partially released from the encapsulant, encapsulant scrap and connection ribbons (5). The solution contains organic residues resulting from backsheet and encapsulant layer oxidation (approximatively 11 wt.% of total weight of the module). The gaseous phase (reactor residual pressure approximatively 0.25 MPa) contains carbon dioxide formed by complete oxidation of a part of polymers materials. Connection ribbons/glass/solar cells fragments mix could be separated by subsequent mechanical process.

### Example 7: method with water in subcritical atmosphere- under permanent O₂ supply

First process consisting in removing mechanically the junction box (2) and aluminum frame (1) from the out-of-order photovoltaic module (8) is identical to the primary dismantling described above in the example 1. After this first process, the core of the panel is introduced into the reactor (Parr instruments model 4580 hydrothermal bomb) (figure 2) and exposed to subcritical atmosphere. Regarding this example, the subcritical atmosphere is formed by water as medium. Reactor dimensions and capacity is identical than previously described in example 1. Regarding this example, the medium is made of water with quantity of 2.4l. Inside this reactor, the atmosphere temperature was set to 190°C. The autogenous pressure was controlled and measured with value around 1.2 MPa. When temperature reaches 190°C inside the reactor tank, a pressure of 0.1 MPa of dioxygen gaz (O₂) was added to the subcritical atmosphere. As oxygen was consumed, reactor tank was continuously fed with oxygen by step of 0.1 MPa. These atmosphere conditions were guaranteed for holding time of 4 hours. Exposed to the oxidant subcritical atmosphere of the reactor, protective glass (3) almost completely peel off from the core of photovoltaic module (figure 3) and backsheet (7) almost totally breaks up due to oxidation of polymers materials. The residual laminate (10) constituted of photoactive material and its connection ribbons embedded between encapsulant layers, needs subsequent treatment to recover the other components. It could be the process described in the example 1 or in the example 6 or 7.

## Claims

1. A method for recycling/recovering a core of a silicon solar cells module(9) in its raw components comprising :
a) providing a core (9) of a silicon solar cells module wherein the cells (6) are interconnected by connection ribbons (5) and embedded in an encapsulation layer (4) said encapsulation layer(4) being sandwiched between a back sheet (7) and a front glass plate (3) ;
b) introducing the core (9) of the silicon solar cells into a reactor;
c) dismantling the solar cells core by hydrothermal treatment under subcritical atmosphere to generate recovered clean glass component and a residual laminate (10).

2. A method according to claim 1 wherein the hydrothermal treatment under subcritical atmosphere is an oxidant hydrothermal treatment.

3. A method according to claim 1 or 2 further comprising an additional treatment of the residual laminate to recover silicon.

4. A method according to claim 3 wherein such additional treatment is a second oxidant hydrothermal treatment

5. A method according to anyone of claim 2 to 4 wherein the oxidant hydrothermal treatment comprises an acid selected from nitric acid, hydrogen peroxide or a mixture thereof.

6. A method according to claim 5 wherein a nitric acid atmosphere is generated from a water medium comprising between 30 and 65 wt.% nitric acid, preferably between 30 and 35 wt.%, most preferably 32 wt.%.

7. A method according to claim 5 wherein nitric acid and hydrogen peroxide are mixed in a ratio from 2:1

8. A method according to anyone of claim 2-7 wherein the oxidant hydrothermal treatment is generated at a temperature between 130°C and 150°C.

9. A method according to anyone of claim 1 to 8 wherein the oxidant hydrothermal treatment is maintained during 3 to 6 hours at an autogenous pressure between 0.5 and 2.5 MPa

10. A method according to anyone of claim 2 to 4 wherein the oxidant hydrothermal treatment comprises an oxidant gas.

11. A method according to claim 10 wherein the oxidant gas is oxygen.

12. A method according to claim 11 wherein oxygen is provided in the reactor at a pressure of 0.1 MPa

13. A method according to anyone of claim 10 to 12 wherein the oxidant hydrothermal treatment is generated at a temperature between 150°C and 250°C, preferably 190°C.

14. A method according to anyone of claim 10 to 13 wherein the oxidant hydrothermal treatment is maintained during 3 to 6 hours with a permanent supply of oxidant gas
